(19) **Europäisches Patentamt European Patent Office Office européen des brevets**

(11) **EP 4 773 785 A1**

(12) **EUROPEAN PATENT APPLICATION**
published in accordance with Art. 153(4) EPC

(43) Date of publication:
08.07.2026 Bulletin 2026/28

(21) Application number: 23814512.2

(22) Date of filing: 24.10.2023

(51) International Patent Classification (IPC):
$H10N\ 30/80\ ^{(2023.01)}$     $H10N\ 30/88\ ^{(2023.01)}$
$F03G\ 1/00\ ^{(2006.01)}$     $H10N\ 30/50\ ^{(2023.01)}$

(52) Cooperative Patent Classification (CPC):
H10N 30/503; B64G 1/409; F03H 99/00;
H10N 30/80; H10N 30/802; H10N 30/886

(86) International application number:
PCT/ES2023/070625

(87) International publication number:
WO 2025/088226 (01.05.2025 Gazette 2025/18)

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Arquimea Group S.A.**
**28850, Torrejón de Ardoz Madrid (ES)**

(72) Inventors:
• **ACQUAVIVA, Giovanni**
**38320 San Cristóbal de la Laguna**
**(Santa Cruz de Tenerife) (ES)**
• **FERNÁNDEZ INFANTE, Diego**
**38320 San Cristóbal de la Laguna**
**(Santa Cruz de Tenerife) (ES)**

(74) Representative: **Elion IP, S.L.**
**Paseo Castellana, 150-4 dcha**
**28046 Madrid (ES)**

(54) **PIEZOELECTRIC THRUSTER AND METHOD FOR GENERATING A THRUST WITH SAID PIEZOELECTRIC THRUSTER**

(57)     Piezoelectric thruster comprising:
- a set of identical piezoelectric elements in the form of a stack (5) of piezoelectric discs (2) polarised in alternating arrangement with respect to conductive electrodes (1), the piezoelectric discs and the electrodes (1) being joined together by an epoxy resin (3)
- two parts, a smaller part (6) and a larger part (7) between which the stacks (5) are arranged with pressure being applied and the piezoelectric discs having a high quality factor Q and a high piezoelectric constant d33;
- a power supply (21) capable of providing an alternating current waveform, wherein the waveform has two sinusoidal components with different frequencies,

A piezoelectric thruster with very low energy loss due to thermal effects is achieved, where the power delivered to the piezoelectric material is maximum, piezoelectric materials have a high mechanical excursion.

FIG.2

EP 4 773 785 A1

**Description**

## OBJECT OF THE INVENTION

The object of the present invention, as the title establishes, is a piezoelectric thruster. A piezoelectric material can convert mechanical stress into electric current and vice versa: when its structure is mechanically deformed, an electric voltage is produced (direct piezoelectric effect); similarly, when an external electric voltage is applied, its structure is deformed (inverse piezoelectric effect). The deformation magnitude and voltage amplitude are linearly proportional for most piezoelectric materials.

An object of the present invention is also a method for generating thrust with the piezoelectric thruster object of the invention.

The present invention is characterised by the special design and configuration of each and every one of the parts that make up the piezoelectric thruster, as well as the stages of the method of generating a thrust with a piezoelectric material.

The present invention takes advantage of the inverse piezoelectric effect in certain piezoelectric materials to transform an alternating electrical signal with a specific profile into directed movement.

Therefore, the present invention is circumscribed within the scope of piezoelectric materials and more precisely from among those used in space applications for manoeuvring and attitude control of satellites in the Earth's orbit, or a small but continuous linear thrust for deep space probes.

## BACKGROUND OF THE INVENTION

In the prior art, patent US2023208321A1 discloses a method for producing accelerations without expelling any exhaust material that is based on inducing mass fluctuations in conventional electrical circuit components and combining them with a mechanically coupled periodic thrust to produce propulsive forces without the expulsion of any propellant. Ferroelectric force transducers, in particular piezoelectric transducers, are driven by at least two phase-locked voltage waveforms, so that both the rest mass fluctuation and the mechanical excursion required to produce a stationary thrust occur in the transducer itself. Parametric amplification is used to obtain large amplitude, correctly synchronised voltages of correct frequencies to drive the transducer by simply adding a DC voltage to the AC voltage of a single frequency driving signal. Control voltage waveforms can be pulsed to maximise thrust and reduce the working cycle of active system components.

However, said embodiment has aspects that are susceptible of being improved and that acting synergistically produce as a result a greater and more effective controlled propulsion. For example, the reduction of the heating rate and the activation of vibrational thermal convection effects that generate thrust.

Therefore, it is the object of the present invention to develop a piezoelectric thruster which has a very low energy loss due to thermal effects, where the power delivered to the piezoelectric material is maximum, and the piezoelectric materials have a large mechanical excursion.

## DESCRIPTION OF THE INVENTION

The object of the present invention is essentially contained in the independent claim and the different embodiments are contained in the dependent claims.

The present invention relates to a piezoelectric thruster comprising:

a. A set of identical piezoelectric elements,

   i. wherein each piezoelectric element is a stack of piezoelectric discs polarised in alternating arrangement with respect to conductive electrodes;

   ii. wherein the thin polarised piezoelectric disc material has a quality factor Q greater than 1800 and a piezoelectric constant $d_{33}$ greater than $270*10^{-12}$ m/V, combined conditions leading to a large mechanical excursion of the piezoelectric elements and a negligible amount of energy lost due to thermal effects during such excursions;

   iii. wherein each side of each thin polarised piezoelectric disc of the stack is covered by a conductive electrode;

   iv. wherein the polarised piezoelectric discs and the conductive electrodes are joined together with a layer of electrically conductive epoxy resin;

   v. wherein each polarised piezoelectric disc of the stack is oriented such that the side with positive polarity is oriented toward the side with positive polarity of the neighbouring thin polarised piezoelectric discs, and the end polarised piezoelectric discs of the stack have the side with positive polarity oriented toward the centre of the stack;

vi. wherein the conductive electrodes have protruding tabs to facilitate electrical connections;
vii. wherein the tabs of the electrodes in contact with the positive polarity of the polarised piezoelectric discs are aligned with each other, on the diametrically opposite side of the stack relative to the tabs of the electrodes in contact with the negative polarity of the polarised piezoelectric discs;

b. two unequal metal pieces, a smaller piece and a larger piece in parallel arrangement and placed at the ends of the stacks

i. wherein a set of screws allows compressing the set of piezoelectric discs, along its axis of symmetry, between the two unequal parts and;
ii. wherein the materials of the unequal metal parts and of the screws are such that the required preload on the piezoelectric elements can be withstood homogeneously and without inducing harmful deformations of the piezoelectric elements, of the unequal metal parts or of the screws, wherein the material of the smaller part must be less dense than the material of the larger part

c. a power supply capable of providing an alternating current waveform,

i. wherein the supply comprises a generator of arbitrary waveform, an amplifier and a transformer;
ii. wherein the positive pole of the supply is connected by electric wires to the tabs of the conductive electrode that are in contact with the positive polarity of the polarised piezoelectric discs of each piezoelectric element, while the negative pole of the supply is connected by electric wires to the conductive electrode tabs that are in contact with the negative polarity of the polarised piezoelectric discs of each piezoelectric element.

**In** a non-limiting preferred embodiment the total pressure exerted by the preload on the stacks should preferably be of the order of ~20 MPa

Furthermore, a phase detector, which calculates the impedance phase angle (IPA) between the voltage and current waveforms that sets a desired phase angle and a phase controller varies the drive frequency to maintain it independent of shifts due to thermal effects, is implemented in the power supply in a complementary manner.

In one possible embodiment, since the material of the smaller part must be less dense than the material of the larger part, the material of the larger part (7) is brass and the material of the smaller part (6) is aluminium.

The piezoelectric thruster additionally comprises a thermal cooling system to avoid large changes in the resonance condition, where the larger part as well as the smaller part have through-holes wherethrough a pipe is arranged along the axis of symmetry of the structure, and wherethrough a liquid coolant is pumped from one side of the pipe to the other with the pipe passing close to the stack assembly. Such piping may be made of aluminium externally coated with black matte paint. Additionally, the thruster would be protected by an external heat shield designed to reflect incident solar radiation to reduce heating due to ambient conditions.

Also, an object of the present invention is a method for generating a thrust without expelling propellant, based on the above-described piezoelectric thruster comprising the stages of:

a. Compressing the piezoelectric element assembly, along its axis of symmetry, between the two unequal masses;
b. Applying an alternating voltage to the piezoelectric element assembly across the conductive electrode tabs,

i. wherein the applied alternating voltage has a waveform comprising two sinusoidal components with different frequencies, the first sinusoidal component with frequency equal to the thickness resonance frequency or first harmonic of the piezoelectric elements, and the second sinusoidal component with frequency equal to twice the thickness resonance frequency or second harmonic of the piezoelectric elements;
ii. where the amplitude of the second sinusoidal component is no more than 20% of the amplitude of the first sinusoidal component, and the phase relationship between the two sinusoidal components of the waveform is $\pi/2$, so that the second derivative of the voltage waveform, which is proportional to the stack acceleration, reaches higher positive values than negative values during each cycle, giving an acceleration during the expansion phase of the piezoelectric elements higher than the acceleration during the contraction phase;
iii. wherein, upon application of the alternating voltage on the piezoelectric elements, and due to the higher acceleration of the expansion, a thrust is produced along the axis of symmetry of the piezoelectric elements in the direction connecting the piezoelectric elements with the larger metal part;

c. measuring both the impedance of the piezoelectric elements and the phase angle between the voltage and current waveforms supplied to the piezoelectric elements, in order to identify the piezoelectric element thickness resonance condition as the frequency range wherein both the impedance is at a local minimum and the phase angle between the voltage and current waveforms is zero;

the method may further include adding an arbitrary number of higher harmonics of the thickness resonance frequency in the alternating voltage waveform, with amplitudes and relative phase suitably chosen so that the second derivative of the voltage waveform, which is proportional to the acceleration of the stack, reaches positive values greater than negative values during each cycle, resulting in an acceleration during the expansion phase of the piezoelectric elements greater than the acceleration during the contraction phase.

In another embodiment, the method may further comprise one or more systems for stabilising the thickness resonance condition of the piezoelectric element over long periods of time, namely:

a. a closed-loop system that measures and tracks the thickness resonance condition of the piezoelectric elements throughout the duration of the AC power supply, and communicates it to the arbitrary waveform generator, so that the arbitrary waveform generator adapts the supplied waveform to the changing resonance condition;

b. supplying the alternating voltage in short pulses, to limit the heating of the piezoelectric elements produced by continuous activation, and to limit the consequent drift of the resonance condition,

i.wherein the periods of the pulses are much longer than one cycle of the alternating voltage, thus allowing several acceleration cycles within the same pulse;

c. a system for cooling piezoelectric elements by absorbing their emitted thermal radiation by means of a material with an absorptivity greater than 0.9 and a thermal conductivity greater than 230 W/) m*K,

i.wherein the cooling system includes a sensor for monitoring the temperature of the piezoelectric elements;

ii. wherein the material with an absorptivity greater than 0.9 and a thermal conductivity greater than 230 W/m*K is in the form of a tube that passes close to the piezoelectric elements and allows a cooling liquid to be pumped and flow inside it.

iii. Wherein the tube passing close to the piezoelectric elements would be made of aluminium with a high thermal conductivity (greater than 230 W/m*K), externally coated with black matte paint with a high absorptivity (greater than 0.9).

Thanks to the claimed characteristics, a piezoelectric thruster with very low energy loss due to thermal effects is achieved, where the power delivered to the piezoelectric material is maximum, the piezoelectric materials have a great mechanical excursion due to the use of higher quality factors, a higher piezoelectric constant among other characteristic elements.

Unless indicated otherwise, all the technical and scientific elements used in this specification have the meaning usually understood by a person skilled in the art to which this invention belongs. In the practice of this invention, methods and materials similar or equivalent to those described in the specification may be used.

In the description and claims, the word "comprises" and its variants do not intend to exclude other technical characteristics, additives, components or steps. For persons skilled in the art, other objects, advantages and characteristics of the invention will be partly inferred from the description and partly from the practice of the invention.

## EXPLANATION OF THE FIGURES

In order to complement the description being made herein, and with the object of aiding the better understanding of the characteristics of the invention, in accordance with a preferred practical embodiment thereof, said description is accompanied, as an integral part thereof, by a set of drawings where, in an illustrative and non-limiting manner, the following has been represented:

Figure 1 is a diagram of a piezoelectric stack assembly.

Figure 2 is an embodiment of the thruster, containing five identical versions of the stack of Figure 1.

Figure 3 shows a diagram of the electronic architecture used to activate and control the thruster.

Figure 4 is an alternative embodiment of the thruster that includes adapting the structure for an active cooling system.

Figure 5 shows the displacement and acceleration of the piezoelectric stack for different values of the relative phase between the sinusoidal components of the trigger signal.

Figure 6 shows the average displacements measured by micrometric equipment during thruster activation.

Figure 7 shows the displacement and acceleration of the piezoelectric stack when the third harmonic of the piezoelectric material resonance is excluded or included in the trigger signal.

## PREFERRED EMBODIMENT OF THE INVENTION

In view of the figures, a preferred embodiment of the proposed invention is described below.

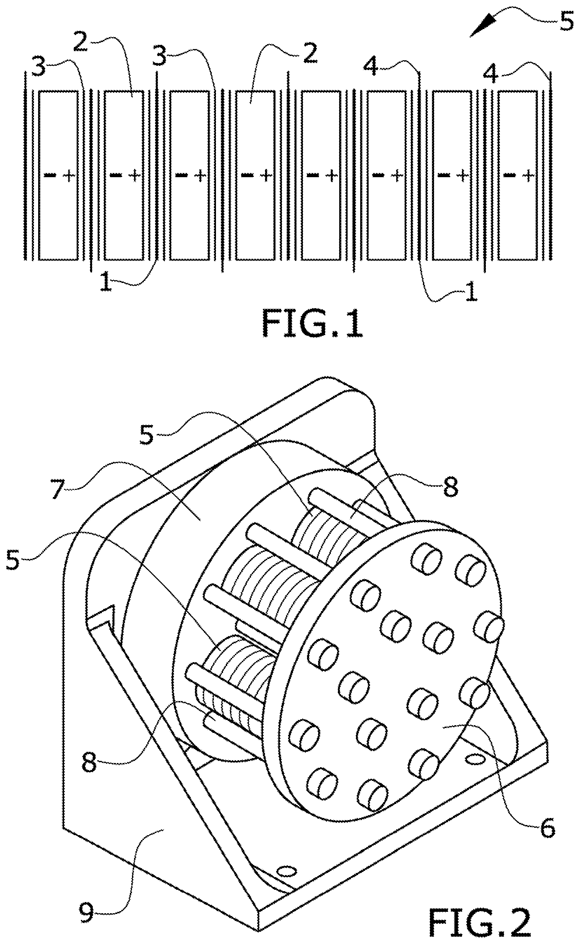

Figure 1 shows a piezoelectric stack (5) comprising a series of thin piezoelectric discs (2) arranged in alignment and separated from each other by means of a series of conductive electrodes (1) sandwiched between the piezoelectric discs (2), the piezoelectric discs (2) being joined to the conductive electrodes (1) by means of an electrically conductive epoxy resin (3), forming what we call a stack.

The electrodes should have protruding tabs (4) to facilitate alternate electrical connections.

The piezoelectric discs (2) must have a high value of piezoelectric constant $d_{33}$ and a high value of quality factor Q (or, equivalently, a low dissipation factor $\tan(\delta)$).

Each polarised piezoelectric disc of the stack is oriented such that the side with positive polarity is oriented toward the side with positive polarity of the neighbouring thin polarised piezoelectric discs, and the end polarised piezoelectric discs of the stack have the side with positive polarity oriented toward the centre of the stack;

The tabs of the electrodes in contact with the positive polarity of the polarised piezoelectric discs are aligned with each other, on the diametrically opposite side of the stack relative to the tabs of the electrodes in contact with the negative polarity of the polarised piezoelectric discs, as can be seen in figure 1.

The piezoelectric coefficient $d_{33}$ measures the deformation of the stack in the same direction of the applied potential: a high value of this coefficient results in a higher deformation compared to materials with lower $d_{33}$ under the same stress. This allows for greater mechanical excursion which facilitates thrust generation.

The quality factor Q describes the quality of an oscillator under resonance conditions: Piezoelectric materials with higher Q-factors exhibit a stronger and more stable resonance, but with a narrower available bandwidth around the resonance frequency, which means that finer tuning is needed to locate the resonance.

Equivalently, a high Q indicates a low rate of energy loss due to thermal effects (low dissipation factor $\tan(\delta)$), so that less heating of the propellant can be achieved.

In one possible embodiment, the thin polarised piezoelectric disc material has a quality factor Q greater than 1800 and a piezoelectric constant $d_{33}$ greater than $270*10^{-12}$ m/V, combined conditions leading to a large mechanical excursion of the piezoelectric elements and a negligible amount of energy lost due to thermal effects during such excursions;

Figure 2 shows the configuration of the piezoelectric thruster object of the invention, which as can be seen, comprises a series of stacks (5) shaped as described in Figure 1, arranged in parallel and compressed between a smaller part (6) and a larger part (7), where the concept of smaller part and larger part refers to their masses; where both parts are joined by a series of screws (8) since the piezoelectric elements need to be subjected to a preload to function correctly and transmit any thrust. The number and arrangement of the preload are such that the pressure exerted on the faces of the stacks is as homogeneous as possible. The total pressure exerted by the preload on the stacks should preferably be of the order of ~20 MP which is a necessary and sufficient pressure to allow a correct acting behaviour of the stacks and at the same time to avoid buckling of the stacks.

The ratio between the radius and the length of the cylindrical stacks must be such that no buckling occurs during preloading. The larger part (7), in addition to acting as a support for the preloading of the stacks, constitutes the point of contact between the thruster and the body on which the force is to be applied.

In addition, an additional support (9) for the thruster can be included to facilitate the assembly process. The choice of materials for the unequal metal parts is governed by both structural requirements (limiting the overall deformation of the parts during preload and activation) and practical considerations (limiting the overall mass of the thruster while providing preload). In accordance with these requirements, and given the relatively low preload needed to compress the stacks, the material of the smaller part (6) should be less dense than the material of the larger part (7). For example, the larger part (7) could be made of brass and the smaller part (6) of aluminium.

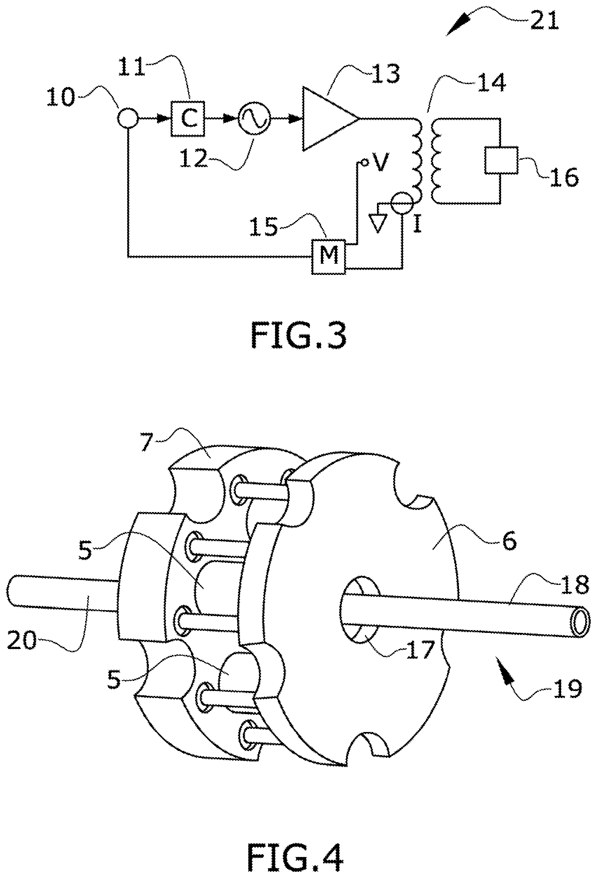

Figure 3 shows the external supply for applying an alternating voltage comprising a signal generator (12), an amplifier (13) and a transformer (14) through which output a modulated alternating voltage is applied across the electrodes of each of the parallel stacks (16), following the alternating pattern shown in Figure 1.

The simplest voltage waveform consists of two main frequencies, the thickness resonance frequency $\omega$ of the piezoelectric element and its double, with a fixed phase relationship of $\pi/2$ between them and a possible amplitude relationship could be approximately 0.177. An explicit form of the signal can be given as in equation [1]:

$$V = \frac{V_0}{1 + 0.177} \left[ sin(\omega\,t) + 0.177\,sin(2\,\omega\,t + \pi/2) \right]$$

The resonance frequency of a piezoelectric material is the frequency at which it exhibits maximum amplitude of oscillations when subjected to an external electric field. The resonance condition corresponds to the point at which the impedance phase angle (IPA) $\theta$ between the voltage and current waveforms is zero, so that the power delivered to the piezoelectric material is maximum, according to equation [2]:

$$P = \frac{1}{2}\,V_p\,I_p\,cos\,\theta \quad \text{with} \quad \theta = 0 \quad \Rightarrow \quad \frac{1}{2}\,V_p\,I_p$$

Where $V_p$ and $I_p$ are the peak voltage and current values, respectively. The addition of a component corresponding to the second harmonic (twice the resonance frequency) induces larger oscillating displacements, while increasing robustness and stability against the non-linear effects of the resonance condition.

The location of the resonance condition of a piezoelectric material in the frequency spectrum may change during operation, due to temperature changes that inevitably occur as the piezoelectric material converts electrical energy into mechanical energy. Two methods are implemented to prevent this effect from affecting thruster performance. On the one hand, to maintain the zero IPA condition, a phase detector (15) is implemented, which calculates the IPA between the voltage and current waveforms; once the desired phase angle (10) is set, a phase controller (11) varies the drive frequency to maintain it independently of shifts due to thermal effects.

On the other hand, a thermal cooling system can be implemented to avoid large changes in the resonance condition, as shown in Figure 4, where the larger part (7) and the smaller part (6) have through-holes (17) that allow the installation of a pipe (18) along the axis of symmetry of the structure. An external system is used to pump liquid coolant through the piping from one side (19) to the other (20) of the structure, with the pipe passing close to the stack assembly (5). To facilitate the transfer of heat radiation from the stacks (5) to the pipe (18), the latter should be made of a material with high absorptivity (greater than 0.9), so that it can effectively absorb thermal infrared radiation, and high thermal conductivity (greater than 230 W/m*K), so that it can quickly transfer heat to the outside. For example, the material for the tube is aluminium externally coated with black matte paint, which together have these two properties.

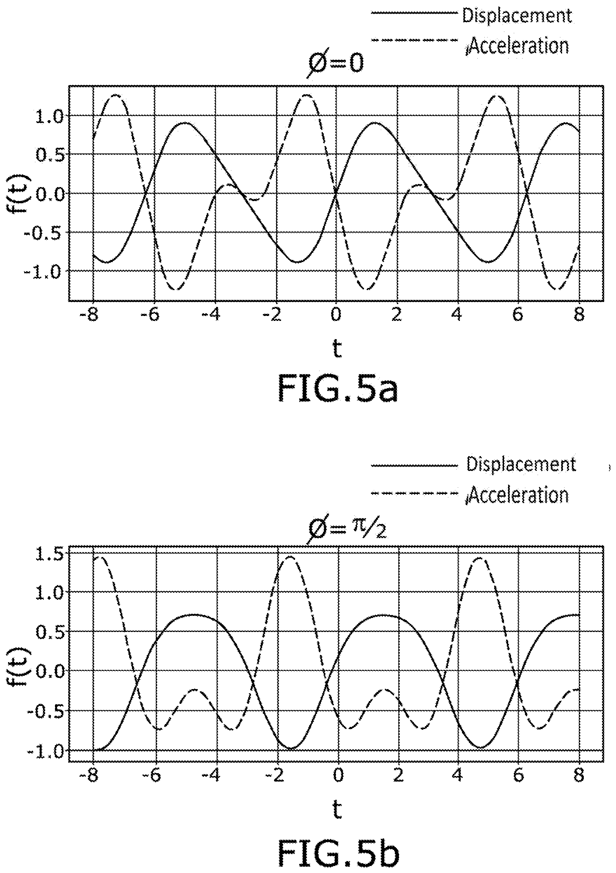

Figure 5a shows how the deformation of a piezoelectric material is proportional to the applied voltage, in the case of a simple sinusoidal waveform the acceleration (i.e. the second derivative of the displacement) of the piezoelectric material during a cycle would have positive and negative peaks with the same amplitude.

Figure 5b shows how the chosen phase difference between the two sinusoidal components maximises the asymmetry of the acceleration, so that it will reach higher positive values than negative ones during each cycle. The asymmetric profile of the excitation signal and the asymmetric arrangement of the metal parts in compression lead to the production of a net acceleration in the direction of the larger part.

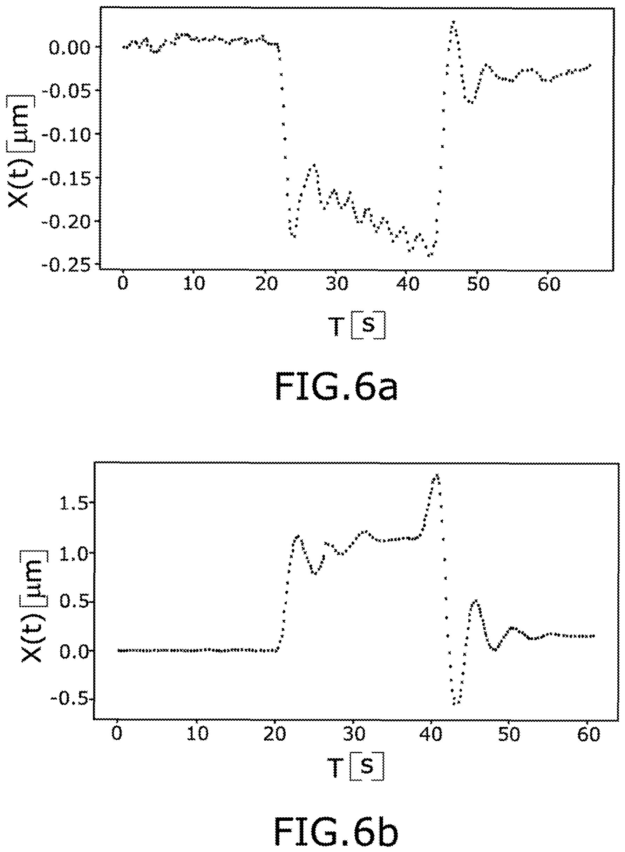

Figures 6a and 6b show the results of experiments to measure the displacement induced by the thruster during its activation in a micrometric device. The signal used to activate the thruster is given in equation [1] with $V_0$=50V. Each graph is an average of several 20-second activations, performed in both directions (conventionally defined) forward (a) and backward (b). By calibrating the micrometric equipment, it is possible to relate the measured displacement with an impulse value given by the thruster: (a) 5.8 $\mu$N and (b) 17 $\mu$N.

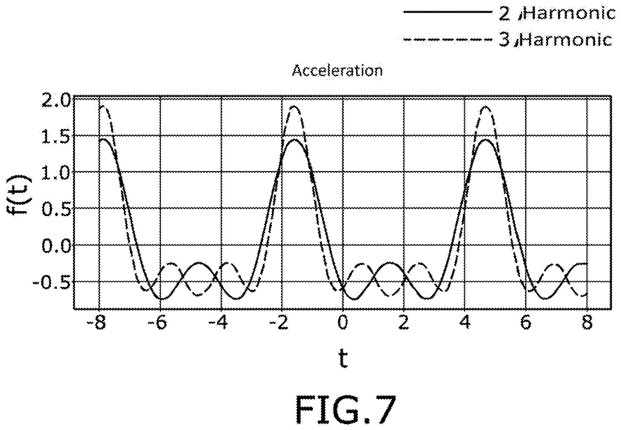

In principle, an amplification of the effect could be obtained by choosing an extended waveform that also includes higher order harmonics of the fundamental resonance frequency, which are theoretically infinite but of progressively decreasing intensity. The resulting signal would be a sum of terms of the form A sin(n $\omega$ t+$\varphi$), where the amplitudes A and phases $\varphi$ should be tuned so as to satisfy the asymmetric acceleration condition described above. Figure 7 shows how the inclusion of the third harmonic, according to equation [3] below, affects the acceleration profile.

$$V = \frac{V_0}{1 + 0.177} \left[ sin(\omega\,t) + 0.177\,sin(2\,\omega\,t + \pi/2) + 0.06\,sin(3\,\omega\,t + \pi) \right]$$

The effect is an increase in asymmetry toward positive values. However, it must be considered that, in some cases, the upper harmonics of the thickness resonance could overlap with frequencies of other types of piezoelectric resonances, such as radials, which would couple and interfere negatively with the required behaviour, so that the net effect could be weakened. The removal of unwanted resonances can be achieved by properly designing the shape of the stacks, which, however, can also lead to unwanted mechanical problems in the preload phase. In this sense, the choice of activating the piezoelectric material only with the fundamental frequency and the second harmonic provides better control over the result.

Having sufficiently described the nature of the present invention, in addition to the manner in which to put it into practice, it is hereby stated that, in its essence, it may be put into practice in other embodiments that differ in detail from that indicated by way of example, and to which the protection equally applies, provided that its main principle is not altered, changed or modified.

**Claims**

1. Piezoelectric thruster **characterised in that** it comprises

    a. A set of identical piezoelectric elements,

        i. wherein each piezoelectric element is a stack (5) of piezoelectric discs (2) polarised in alternating arrangement with respect to conductive electrodes (1);
        ii. wherein the thin polarised piezoelectric disc material has a quality factor Q greater than 1800 and a piezoelectric constant $d_{33}$ greater than $270*10^- 12$ m/V;
        iii. wherein each side of each thin polarised piezoelectric disc (2) of the stack (5) is covered by a conductive electrode (1);
        iv. wherein the polarised piezoelectric discs (2) and the conductive electrodes (1) are joined together with a layer of electrically conductive epoxy resin (3);
        v. wherein each polarised piezoelectric disc (2) of the stack (5) is oriented such that the side with positive polarity is oriented toward the side with positive polarity of the neighbouring thin polarised piezoelectric discs (2), and the end polarised piezoelectric discs (2) of the stack have the side with positive polarity oriented toward the centre of the stack;
        vi. wherein the conductive electrodes (1) have protruding tabs (4) to facilitate electrical connections;
        vii. wherein the tabs of the electrodes (1) in contact with the positive polarity of the polarised piezoelectric discs (2) are aligned with each other, on the diametrically opposite side of the stack relative to the tabs of the electrodes in contact with the negative polarity of the polarised piezoelectric discs (2);

    b. two unequal metal pieces, a smaller piece (6) and a larger piece (7) in parallel arrangement and placed at the ends of the stacks (5),

        i. wherein a set of screws (8) allows compressing the set of piezoelectric discs (2), along its axis of symmetry, between the two unequal parts (6) and (7);
        ii. wherein the materials of the unequal metal parts and of the screws are such that the required preload on the piezoelectric elements can be withstood homogeneously and without inducing harmful deformations of the piezoelectric elements, of the unequal metal parts or of the screws, wherein the material of the smaller part (6) must be less dense than the material of the larger part (7)

    c. a power supply (21) capable of providing an alternating current waveform,

        i. wherein the supply comprises a generator (12) of arbitrary waveform, an amplifier (13) and a transformer (14);
        ii. wherein the positive pole of the supply (21) is connected by electric wires to the tabs of the conductive electrode (1) that are in contact with the positive polarity of the polarised piezoelectric discs (2) of each piezoelectric element, while the negative pole of the supply is connected by electric wires to the conductive electrode tabs that are in contact with the negative polarity of the polarised piezoelectric discs (2) of each piezoelectric element.

2. Piezoelectric thruster according to claim 1, **characterised in that** the total pressure exerted by the preload on the stacks should preferably be of the order of ~20 MP

3. Piezoelectric thruster according to claim 1, **characterised in that** a phase detector (15) is implemented in the power supply (21), which calculates the impedance phase angle (IPA) between voltage and current waveforms that sets a desired phase angle (10) and a phase controller (11) varies the drive frequency to keep it independent of shifts due to thermal effects.

4. Piezoelectric thruster according to any of the previous claims, **characterised in that** the material of the larger part (7) is brass and that of the smaller part (6) is aluminium.

5. Piezoelectric thruster according to any of the preceding claims, **characterised in that** it comprises a thermal cooling system to avoid large changes in the resonance condition, wherein the larger part (7) and the smaller part (6) have through-holes (17) wherethrough a pipe (18) is arranged along the axis of axis of symmetry of the structure, and wherethrough a liquid coolant is pumped from one side (19) to the other (20) of the pipe (18) with the pipe passing close to the stack assembly (5).

6. Piezoelectric thruster according to claim 5, **characterised in that** the pipe (18) is made of aluminium externally coated with black matte paint.

7. A method for generating thrust without expelling propellant, based on the piezoelectric thruster according to any one of claims 1 to 6, **characterised in that** it comprises the steps of:

   a. Compressing the piezoelectric element assembly, along its axis of symmetry, between the smaller part (6) and the larger part (7);
   b. Applying an alternating voltage to the piezoelectric element assembly across the conductive electrode tabs,

       i. wherein the applied alternating voltage has a waveform comprising two sinusoidal components with different frequencies, the first sinusoidal component with frequency equal to the thickness resonance frequency or first harmonic of the piezoelectric elements, and the second sinusoidal component with frequency equal to twice the thickness resonance frequency or second harmonic of the piezoelectric elements;
       ii. where the amplitude of the second sinusoidal component is no more than 20% of the amplitude of the first sinusoidal component, and the phase relationship between the two sinusoidal components of the waveform is $\pi/2$.
       iii. wherein, upon application of the alternating voltage on the piezoelectric elements, and due to the higher acceleration of the expansion, a thrust is produced along the axis of symmetry of the piezoelectric elements in the direction connecting the piezoelectric elements with the larger metal part;

   c. measuring both the impedance of the piezoelectric elements and the phase angle between the voltage and current waveforms supplied to the piezoelectric elements, in order to identify the piezoelectric element thickness resonance condition as the frequency range wherein both the impedance is at a local minimum and the phase angle between the voltage and current waveforms is zero.

8. A method for generating a thrust without expelling propellant according to claim 7, **characterised in that** it further includes adding a number of higher harmonics of the thickness resonance frequency in the alternating voltage waveform, with amplitudes and relative phase chosen so that the second derivative of the voltage waveform, which is proportional to the acceleration of the stack, reaches positive values greater than the negative values during each cycle.

9. A method for generating a thrust without expelling propellant according to claim 7 or 8, **characterised in that** it further includes one or more systems for stabilising the thickness resonance condition of the piezoelectric element for periods of time greater than 1 day, namely:

   a. a closed-loop system that measures and tracks the thickness resonance condition of the piezoelectric elements throughout the duration of the AC power supply, and communicates it to the arbitrary waveform generator, so that the arbitrary waveform generator adapts the supplied waveform to the changing resonance condition;
   b. supplying the alternating voltage in short pulses, to limit the heating of the piezoelectric elements produced by continuous activation, and to limit the consequent drift of the resonance condition,

       i. wherein the periods of the pulses are much longer than one cycle of the alternating voltage, thus allowing several acceleration cycles within the same pulse;

   c. a system for cooling piezoelectric elements by absorbing their emitted thermal radiation by means of a material with an absorptivity greater than 0.9 and a thermal conductivity greater than 230 W/m*K,

i.wherein the cooling system includes a sensor for monitoring the temperature of the piezoelectric elements;

ii. wherein the material with an absorptivity greater than 0.9 and a thermal conductivity greater than 230 W/m*K is in the form of a tube that passes close to the piezoelectric elements and allows a cooling liquid to be pumped and flow inside it.

10. Method for generating a thrust without expelling propellant according to claim 7 or 8 or 9, **characterised in that** the waveform that consists of two main frequencies have a fixed phase relationship of rr/2 between them and a possible amplitude ratio could be approximately 0.177, wherein the explicit form of the signal as in the equation:

$$V = \frac{V_0}{1 + 0.177} \left[ sin(\omega t) + 0.177 \, sin(2\,\omega t + \pi/2) \right]$$

FIG.1

FIG.2

FIG.3

FIG.4

FIG.5a

FIG.5b

# FIG.6a

# FIG.6b

FIG.7

# INTERNATIONAL SEARCH REPORT

| International application No |
| --- |
| PCT/ES2023/070625 |

**A. CLASSIFICATION OF SUBJECT MATTER**

INV. H10N30/80    H10N30/88    F03G1/00    H10N30/50
ADD.

According to International Patent Classification (IPC) or to both national classification and IPC

**B. FIELDS SEARCHED**

Minimum documentation searched  (classification system followed by classification symbols)

H10N

Documentation searched other than minimum documentation to the extent that such documents are included  in the fields searched

Electronic data base consulted during the  international search (name of data base and,  where practicable, search terms used)

EPO-Internal, WPI Data

**C. DOCUMENTS CONSIDERED TO BE RELEVANT**

| Category* | Citation of document, with indication,  where appropriate, of the relevant passages | Relevant to claim No. |
| --- | --- | --- |
| A | US 9 287 840 B1 (WOODWARD JAMES F [US]) 15 March 2016 (2016-03-15) ----- | 1-10 |
| A | CN 104 811 879 B (CHINESE ACAD INST ACOUSTICS) 3 July 2018 (2018-07-03) ----- | 1-10 |
| A | US 2003/085633 A1 (MARTH HARRY [DE]) 8 May 2003 (2003-05-08) ----- | 1-10 |
| A | US 6 411 009 B2 (EADS DEUTSCHLAND GMBH [DE]) 25 June 2002 (2002-06-25) ----- | 1-10 |

☐ Further documents are listed in the  continuation of Box C.    ☒ See patent family annex.

\* Special categories of cited documents :

"A" document defining the general state of the art which is not considered to be of particular relevance

"E" earlier application or patent but published on or after the international filing date

"L" document which may throw doubts on priority  claim(s) or which is cited to establish the publication date of another  citation or other special reason (as specified)

"O" document referring to an oral disclosure, use,  exhibition or other means

"P" document published prior to the international filing date but later than the priority date claimed

"T" later document published after the international filing date or priority date and not in conflict with the application but cited to understand the principle or theory underlying the invention

"X" document of particular relevance;; the claimed invention cannot be considered novel or cannot be considered to involve an inventive step when the document is taken alone

"Y" document of particular relevance;; the claimed invention cannot be considered to involve an inventive step when the document is combined with one or more other such documents, such combination being obvious to a person skilled in the art

"&" document member of the same patent family

| Date of the actual completion of the international search | Date of mailing of the international search report |
| --- | --- |
| 14 May 2024 | 24/05/2024 |

| Name and mailing address of the ISA/ European Patent Office, P.B. 5818 Patentlaan 2 NL - 2280 HV Rijswijk Tel. (+31-70) 340-2040, Fax: (+31-70) 340-3016 | Authorized officer Koskinen, Timo |
| --- | --- |

Form PCT/ISA/210 (second sheet) (April 2005)

## INTERNATIONAL SEARCH REPORT
Information on patent family members

| International application No |
| --- |
| PCT/ES2023/070625 |

| Patent document cited in search report | | | Publication date | Patent family member(s) | | Publication date |
| --- | --- | --- | --- | --- | --- | --- |
| US 9287840 | B1 | | 15-03-2016 | NONE | | |
| CN 104811879 | B | | 03-07-2018 | NONE | | |
| US 2003085633 | A1 | | 08-05-2003 | DE | 10148267 A1 | 30-01-2003 |
| | | | | EP | 1267478 A2 | 18-12-2002 |
| | | | | EP | 2209202 A2 | 21-07-2010 |
| | | | | EP | 2209203 A2 | 21-07-2010 |
| | | | | US | 2003085633 A1 | 08-05-2003 |
| US 6411009 | B2 | | 25-06-2002 | DE | 19961068 C1 | 25-01-2001 |
| | | | | GB | 2360126 A | 12-09-2001 |
| | | | | IT | 1319145 B1 | 23-09-2003 |
| | | | | US | 2001004181 A1 | 21-06-2001 |

Form PCT/ISA/210 (patent family annex) (April 2005)

16

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2023208321 A1